(19) Europäisches Patentamt
European Patent Office
Office européen des brevets

(11) **EP 2 342 540 B1**

(12) **EUROPÄISCHE PATENTSCHRIFT**

(45) Veröffentlichungstag und Bekanntmachung des Hinweises auf die Patenterteilung:
**08.08.2012 Patentblatt 2012/32**

(21) Anmeldenummer: **09778791.5**

(22) Anmeldetag: **01.10.2009**

(51) Int Cl.:
*G01D 5/249* (2006.01)   *G01D 5/347* (2006.01)
*H03M 1/28* (2006.01)

(86) Internationale Anmeldenummer:
**PCT/EP2009/007041**

(87) Internationale Veröffentlichungsnummer:
**WO 2010/049047 (06.05.2010 Gazette 2010/18)**

(54) **ABSOLUTE WINKELCODIERUNG UND WINKELMESSVORRICHTUNG**

ABSOLUTE ANGLE CODE AND ANGLE MEASURING DEVICE

CODAGE D'ANGLE ABSOLU ET DISPOSITIF DE MESURE D'ANGLE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **30.10.2008 DE 102008053985**

(43) Veröffentlichungstag der Anmeldung:
**13.07.2011 Patentblatt 2011/28**

(73) Patentinhaber: **Dr. Johannes Heidenhain GmbH 83301 Traunreut (DE)**

(72) Erfinder: **LINGK, Christoph 83278 Traunstein (DE)**

(56) Entgegenhaltungen:
**EP-A2- 0 368 605      WO-A1-96/19872
WO-A1-2005/119179   DE-C1- 4 022 503
US-A- 5 751 230**

**Beschreibung**

Auf vielen Gebieten werden zur Bestimmung der Position zweier relativ zueinander bewegter Körper vermehrt absolute Winkelmessvorrichtungen eingesetzt. Absolute Winkelmessvorrichtungen haben gegenüber rein inkremental messenden Systemen den Vorteil, dass in jeder Relativlage auch nach Unterbrechung der Versorgungsenergie sofort eine korrekte Positionsinformation ausgegeben werden kann.

Die absolute Position wird dabei von einer Winkelcodierung verkörpert. Besonders Platz sparend ist die Anordnung der Positionsinformation in einer einzigen Codespur mit in Messrichtung hintereinander angeordneten Codeelementen. Die Codeelemente sind dabei in pseudozufälliger Verteilung hintereinander angeordnet, so dass eine bestimmte Anzahl von aufeinander folgenden Codeelementen jeweils ein Codewort bildet, das die absolute Position eindeutig definiert. Bei der Verschiebung der Abtasteinrichtung relativ zu der Winkelcodierung um ein einziges Codeelement wird bereits ein neues Codewort gebildet und über den gesamten absolut zu erfassenden Umfang (360°) steht eine Folge von unterschiedlichen Codewörtern zur Verfügung. Ein derartiger serieller bzw. sequentieller Code wird auch oft als Kettencode oder als Pseudo-Random-Code (PRC) bezeichnet.

Zur Bestimmung der absoluten Position aus den abgetasteten Codewörtern - auch Decodierung genannt - wird eine Decodiertabelle eingesetzt, in der jedem Codewort eine Position zugeordnet ist. Zur Zuordnung der absoluten Position zu einem abgetasteten Codewort bildet das Codewort die Adresse für die Decodiertabelle, so dass am Ausgang die für dieses Codewort abgelegte absolute Position ansteht und zur Weiterverarbeitung zur Verfügung steht. Diese nichtflüchtigen Tabellen können heute in einem ASIC hardwareverdrahtet ausgelegt sein, um einen schnellen Zugriff zu ermöglichen.

Die Anforderungen an die Auflösung von Winkelmessvorrichtungen werden immer höher, so dass über 360° viele Positionen eindeutig zu codieren sind. Je mehr Positionen codiert werden müssen, um so aufwendiger ist die nachfolgende Decodierung. Problematisch bei einer seriellen Codierung ist, dass für eine hohe Auflösung sehr viele verschiedene Codewörter generiert und decodiert werden müssen. Erfolgt die Decodierung mittels Tabellen, ist eine große Tabelle erforderlich, in der für jedes mögliche Codewort eine dazugehörige absolute Position abgelegt ist. Erfolgt die Decodierung mittels eines Rechners, führt dies zu relativ langen Rechenzeiten.

Die US 6,330,522 B1 zeigt eine Maßnahme auf, wie eine Winkelcodierung und eine Winkelmessvorrichtung ausgestaltet werden kann, um den Aufwand der Decodierung zu verringern. Dabei wird eine erste Codesequenz einer ersten Länge und eine zweite Codesequenz einer zweiten Länge in parallel zueinander verlaufenden Spuren über 360° angeordnet. Die erste Codesequenz ist fünf mal über 360° angeordnet und die zweite Codesequenz ist vierzehn mal über 360° angeordnet. Die Bitbreite der ersten Codesequenz unterscheidet sich von der Bitbreite der zweiten Codesequenz. Die Decodiereinrichtung weist einen ersten Wertevorrat zur Decodierung der ersten Codesequenz sowie einen zweiten Wertevorrat zur Decodierung der zweiten Codesequenz auf. Die absolute Position ist durch die Kombination beider Teilpositionen an jeder Stelle über 360° eindeutig.

Nachteilig bei einer parallelen Anordnung der Codesequenzen ist einerseits die Moiree-Empfindlichkeit bei der Abtastung sowie die relativ geringen absolut codierbaren Positionen über 360°.

Aufgabe der Erfindung ist es daher, eine Winkelmessvorrichtung anzugeben, mit der eine Vielzahl von Positionen über 360° eindeutig codiert werden können, und mit der eine einfache Decodierung der durch Abtastung dieser Winkelcodierung generierten Folgen von Codewörtern ermöglicht wird.

Diese Aufgabe wird durch die im Anspruch 1 angegebene Winkelcodierung gelöst.

Die hierzu verwendete absolute Winkelcodierung weist mehrere innerhalb von 360° angeordnete Codesequenzen auf, die in Kombination die 360° eindeutig absolut codieren. Die erste Codesequenz weist eine erste Länge $L_A$ auf und ist eine erste Anzahl $N_A$ mal aufeinanderfolgend angeordnet, und die zweite Codesequenz weist eine zweite Länge $L_B$ auf und ist eine zweite Anzahl $N_B$ mal aufeinanderfolgend angeordnet, mit

$N_A$ größer gleich 2 sowie ganzzahlig oder nicht ganzzahlig

$N_B$ größer gleich 2 sowie ganzzahlig oder nicht ganzzahlig

$N_A$ ungleich $N_B$

$L_A$ und $L_B$ ganzzahlig

$L_A$ ungleich $L_B$;

Weiterhin ist die erste Codesequenz und die zweite Codesequenz in einer gemeinsamen Spur angeordnet, indem jeweils ein Teil der ersten Codesequenz und ein Teil der zweiten Codesequenz abwechselnd angeordnet ist. Insbesondere folgt auf ein Codeelement der ersten Codesequenz jeweils ein einziges Codeelement der zweiten Codesequenz und auf ein Codeelement der zweiten Codesequenz jeweils ein einziges Codeelement der ersten Codesequenz.

Die Codesequenzen sind dabei kreisförmig an einer Scheibe oder über den Umfang einer Trommel konzentrisch zum Drehpunkt angeordnet. Ein Teil der Codesequenz bedeutet, dass dies ein oder mehrere aufeinanderfolgende Codeelemente dieser Codesequenz sein können. In den nachfolgenden Ausführungsbeispielen ist dieser Teil jeweils ein einziges Codeelement. Dabei ist ein Codeelement jeweils ein Bereich der Winkelcodierung, aus dem ein Bit 0 oder 1 ableitbar ist.

Codesequenz bedeutet eine Abfolge von mehreren Codeelementen, die über die Gesamtlänge der Codesequenz unterschiedliche Positionen im Raster eines Codeelementes definiert.

Zyklisch fortgesetzte Codesequenz bedeutet, dass sich am Ende der Codesequenz der Anfang dieser gleichen Codesequenz wieder anschließt.

Länge einer Codesequenz definiert den Winkelsektor, den eine Codesequenz einschließt. Da die Codeelemente aller Codesequenzen jeweils gleiche Winkelsektoren einschließen, ist die Länge der Codesequenz gleich der Anzahl der Codeelemente innerhalb der Codesequenz und damit die Anzahl der davon ableitbaren Bits.

Zur Generierung einer Schwebung der Positionen beider Codesequenzen ist die Länge der ersten Codesequenz in vorteilhafter Weise kein Vielfaches der Länge der zweiten Codesequenz. Die Schwebungslänge der Codesequenzen ist maximal, wenn sich die Länge der ersten Codesequenz von der Länge der zweiten Codesequenz um 1 unterscheidet, also eine der beiden Codesequenzen ein einziges Codeelement mehr aufweist als die andere der beiden Codesequenzen.

Eine erste besonders einfach zu decodierende Winkelcodierung ergibt sich, wenn über 360° die erste Codesequenz $N_A$ mal und die zweite Codesequenz $N_B$ mal angeordnet ist, mit $N_A$ und $N_B$ ganzzahlig.

Diese endlos über den gesamten Umfang (360°) besonders einfach zu decodierende Winkelcodierung hat $M_1$ verschiedene absolute Positionen über 360°, wenn diese eine Anzahl $M_1 = 2 * KGV (L_A, L_B)$ Codeelemente aufweist, mit

KGV $(L_A, L_B)$ = kleinstes gemeinsames Vielfaches von $L_A$ und $L_B$
$L_A$ = Länge der ersten Codesequenz A
$L_B$ = Länge der zweiten Codesequenz B

Für $N_A$ gilt dann: $N_A = KGV (L_A, L_B) / L_A$
Für $N_B$ gilt dann: $N_B = KGV (L_A, L_B) / L_B$
Die maximale Anzahl verschiedener Positionen ist erreichbar, wenn sich $L_A$ von $L_B$ um 1 unterscheidet. Dann gilt:

$$M_{1max} = 2 * L_A * L_B.$$

Die bei der Abtastung dieser Winkelcodierung mittels einer Detektoranordnung gewonnenen Wörter (Bitpattern) können mittels zweier in einer Decodiereinrichtung zur Verfügung stehender Wertevorräte decodiert werden. Der erste Wertevorrat ist zur Decodierung einer ersten Folge von Codewörtern ausgebildet, die jeweils bei der Abtastung der ersten Codesequenz sowie ihrer zyklischen Fortsetzung entsteht. Der zweite Wertevorrat ist zur Decodierung einer zweiten Folge von Codewörtern ausgebildet, die jeweils bei der Abtastung der zweiten Codesequenz sowie ihrer zyklischen Fortsetzung entsteht.

Das Ergebnis der Decodierung der ersten Folge von Codewörtern ist eine erste Teilposition innerhalb der ersten Codesequenz und das Ergebnis der Decodierung der weiteren Folge von Codewörtern ist eine zweite Teilposition innerhalb der zweiten Codesequenz. Der Gesamt-Positionswert ergibt sich aus beiden Teilpositionen.

Wird über 360° eine von $M_1 = 2 * KGV (L_A, L_B)$ abweichende Anzahl $M_2$ von absoluten Positionen gefordert, insbesondere $M_2 = 2^k$ verschiedene Positionen, dann ist bei einer zweiten Winkelcodierung über 360° die Anzahl der Codeelemente:

$$M_2 < 2 * KGV (L_A, L_B),$$

mit
KGV $(L_A, L_B)$ = kleinstes gemeinsames Vielfaches von $L_A$ und $L_B$
$L_A$ = Länge der ersten Codesequenz A
$L_B$ = Länge der zweiten Codesequenz B

Dabei ist die erste Codesequenz $N_A$ mal angeordnet, mit
$N_A$ größer 2 sowie $N_A$ nicht ganzzahlig,
so dass die erste Codesequenz eine Unterbrechung aufweist, und / oder die zweite Codesequenz $N_B$ mal angeordnet, mit
$N_B$ größer 2 sowie $N_B$ nicht ganzzahlig,
so dass die zweite Codesequenz eine Unterbrechung aufweist.

In anderen Worten ausgedrückt, ist dann zumindest eine der beiden Codesequenzen einmal innerhalb 360° nur teilweise aufgetragen, bzw. der nicht aufgetragene Teil dieser Codesequenz herausgeschnitten und der verbleibende Teil an die nächste Codesequenz angeschlossen. An dieser Anschlussstelle ist diese Codesequenz unterbrochen, da hier ein Stoßbereich entsteht, an dem bei der Abtastung eine neue Folge von Codeelementen, d. h. neue Bitpattern bzw. Wörter, entstehen. Neue Bitpattern bedeutet, dass diese Bitpattern nicht Bestandteil der Codesequenzen und ihrer zyklischen Fortsetzungen ist. Das "Herausschneiden" bzw. die "Unterbrechung" erfolgt an einer Grenze zweier Codeelemente, so dass über 360° immer eine ganze Zahl von Codeelementen aller Codesequenzen vorhanden sind.

Um bei dieser zweiten Winkelcodierung die Codesequenzen gut auszunutzen und eine möglichst hohe Anzahl von Positionen zu ermöglichen, ist in vorteilhafter Weise über 360° die Anzahl

$$M_2 = 2 * (KGV (L_A, L_B) - E * L_A)$$

was bedeutet, dass nur eine der zweiten Codesequenzen B unvollständig ist, oder

$$M_2 = 2 * (KGV (L_A, L_B) - E * L_B)$$

was bedeutet, dass nur eine der ersten Codesequenzen A unvollständig ist. Dabei ist E > 0 und ganzzahlig.

Die zweite Winkelcodierung ermöglicht nun über 360° $M_2 = 2^k$ Codeelemente anzuordnen, mit vorzugsweise k>4 und ganzzahlig.

Zur Decodierung der bei der Abtastung der zweiten Winkelcodierung gewonnenen Wörter wird nun außer dem ersten und zweiten Wertevorrat ein weiterer Wertevorrat erforderlich. Dieser weitere Wertevorrat ist zur Decodierung der Unterbrechung der zyklischen Fortsetzung der ersten und / oder der zweiten Codesequenz, also des Stoßbereiches, ausgelegt und enthält nun die Bitpattern, die bei der Abtastung des Stoßbereichs neu entstehen, also nicht Bestandteil des ersten oder zweiten Wertevorrats sind.

Weitere vorteilhafte Ausgestaltungen der Erfindung sind in den abhängigen Ansprüchen angegeben.

Anhand der Zeichnungen werden Ausführungsbeispiele der Erfindung näher erläutert.

Es zeigt

Figur 1     eine erste Winkelmessvorrichtung mit einer ersten Winkelcodierung in schematischer Darstellung;

Figur 2     ein Bitpattern der Detektoranordnung der ersten Winkelmessvorrichtung;

Figur 3     ein Flussdiagramm und Rechenvorschriften zur Ermittlung der Position mittels der ersten Winkelmessvorrichtung;

Figur 4     ein Diagramm zur Ermittlung der Position aus gelesenen Bitpattern (Wörtern) anhand eines Beispiels der ersten Winkelcodierung;

Figur 5     eine zweite Winkelmessvorrichtung mit einer zweiten Winkelcodierung in schematischer Darstellung;

Figur 6     ein Flussdiagramm und Rechenvorschriften zur Ermittlung der Position mittels der zweiten Winkelmessvorrichtung, und

Figur 7     ein Diagramm zur Ermittlung der Position aus gelesenen Bitpattern (Wörtern) anhand eines Beispiels der zweiten Winkelcodierung.

Bei der Erfindung wird das Nonius-Prinzip eingesetzt. Zur absoluten Positionsmessung werden zwei serielle Codesequenzen A, B eingesetzt, die verschiedene Längen $L_A$, $L_B$ aufweisen. An jeder Position innerhalb des Messbereichs von 360° wird nun die eindeutige absolute Position POS aus der Kombination von Teilpositionen $x_A$, $x_B$ der mehreren seriellen Codesequenzen A, B gewonnen. Der Vorteil einer derartigen Codierung besteht darin, dass die Decodiereinrichtung 3 jeweils nur die relativ kurzen mehreren seriellen Codesequenzen A, B und ihrer zyklischen Fortsetzungen decodieren muss, und dann die eindeutige Position POS über 360° durch relativ einfache Beziehungen aus diesen decodierten Codesequenzen A, B ermittelt werden kann. Erfolgt die Decodierung mittels Tabellen, sind nur mehrere kleine Tabellen erforderlich. Es sind sehr viel weniger Tabelleneinträge notwendig, als absolute Positionen ausgebbar sind.

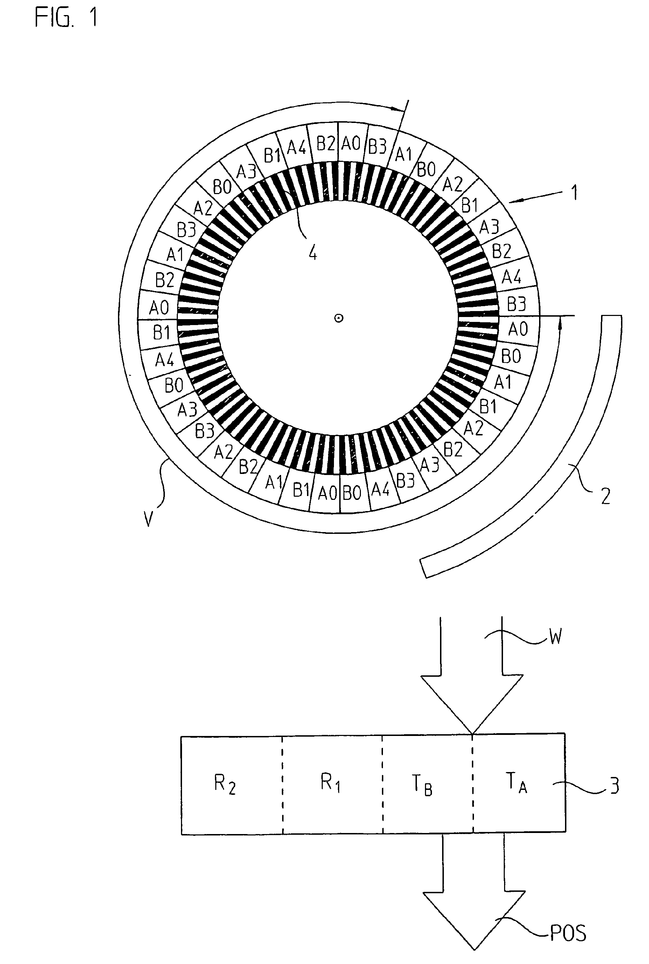

In Figur 1 ist eine erste erfindungsgemäß ausgebildete absolute Winkelcodierung 1 und Winkelmessvorrichtung schematisch dargestellt. Die Winkelcodierung 1 ist derart ausgebildet, dass sie innerhalb einer vollen Umdrehung, also über 360° endlos, an jeder Position eine eindeutige absolute Position POS definiert. Hierzu besteht die Winkelcodierung 1 aus einer hintereinander angeordneten Folge von Codeelementen A0 bis A4 bzw. B0 bis B3, die jeweils einen Winkelsektor gleicher Größe einschließen.

Das Prinzip der Positionsmessung beruht auf der Schwebung von zwei Codesequenzen A, B unterschiedlicher Länge $L_A$ und $L_B$, wobei $L_A$, $L_B$ ganzzahlig und vorzugsweise teilerfremd. Die maximal zu decodierende Länge $M_{1max}$ ergibt sich, wenn sich $L_A$ von $L_B$ um 1 unterscheidet.

Die erste Codesequenz A sei mit der Bitfolge $A_0 A_1 A_2 A_3 ... A_{LA-1}$
der Länge $L_A$ gegeben, und die zweite Codesequenz B durch die Bitfolge $B_0 B_1 B_2 B_3 ... B_{LB-1}$
der Länge $L_B$. Hierbei ist $A_i$, $B_i \in \{0;1\}$. Die Winkelcodierung 1 wird dann durch die abwechselnde Anordnung eines Bits aus der Codesequenz A und dann eines Bits aus der Codesequenz B hergestellt:

$$\left| A_0 B_0 \ A_1 B_1 \ A_2 B_2 \ ... A_{LA-1} B_{LB-1} \right| A_0 B_0 ...$$
$$\longleftarrow M_{1max} = 2 * L_A * L_B \longrightarrow$$

Auf Grund der unterschiedlichen Längen $L_A$, $L_B$ von Codesequenz A und Codesequenz B kommt es zu einer Schwebung zwischen den Codesequenzen A und B. Die gesamte codierbare Länge $M_{1max}$ (also die Länge, nach der sich das Bitmuster wiederholt) ist bei $L_A - L_B = 1$ gegeben durch

$$M_{1max} = 2 * KGV (L_A , L_B) = 2 * L_A * L_B$$

mit KGV $(L_A, L_B)$ = kleinstes gemeinsames Vielfaches von $L_A$ und $L_B$

Erfindungsgemäß sind auch Winkelcodierungen mit Codesequenzen mit beliebiger Längendifferenz $L_A$-$L_B$ möglich. Im Fall $L_A$-$L_B \neq 1$ ist aber die maximal codierbare Länge $M_{1max}$ geringer und der Auswertealgorithmus ggf. aufwändiger, so dass hier nur das besonders vorteilhafte Beispiel mit $L_A$ unterscheidet sich von $L_B$ um 1 detailliert erläutert wird.

Zur Positionsmessung wird die Winkelcodierung 1 beispielsweise optisch abgetastet, indem die Codeelemente ein Lichtbündel positionsabhängig modulieren, so dass am Ort einer Detektoranordnung 2 einer Abtasteinrichtung eine positionsabhängige Lichtverteilung entsteht, die von der Detektoranordnung 2 in elektrische Abtastsignale w gewandelt wird. Die Detektoranordnung 2 ist ein Zeilensensor, mit einer in Messrichtung angeordneten Folge von Detektorelementen. Die Detektorelemente sind derart ausgebildet, dass jedem der Codeelemente in jeder Relativlage zumindest eines der Detektorelemente eindeutig zugeordnet ist, und somit aus jedem der Codeelemente ein Bit 0 oder 1 gewonnen werden kann. Hierzu sind beim optischen Abtastprinzip die Codeelemente reflektierend oder nichtreflektierend, bzw. opak oder nichtopak, wobei den reflektierenden Codeelementen beispielsweise der Bitwert 1 und den nichtreflektierenden Codeelementen der Bitwert 0 zugeordnet wird. Die Abfolge dieser Bits (Bitpattern) innerhalb einer Codesequenz A, B, deren Anzahl abhängig von der Abtastlänge $L_L$ ist, bildet für die beiden Codesequenzen A, B jeweils ein Codewort w. Die Abtastsignale, also die Codeworte w werden einer Decodiereinrichtung 3 zugeführt, welche aus jedem der Codeworte w einer der Codesequenzen A, B eine Teilposition $x_A$, $x_B$ ableitet und aus diesen Teilpositionen $x_A$, $x_B$ dann daraus eine absolute Position POS bildet. Bei einer Verschiebung der Detektoranordnung 2 gegenüber der Winkelcodierung 1 um die Breite bzw. Länge eines Codeelementes A, B wird aus jeder der Codesequenzen A, B jeweils ein neues Codewort w erzeugt.

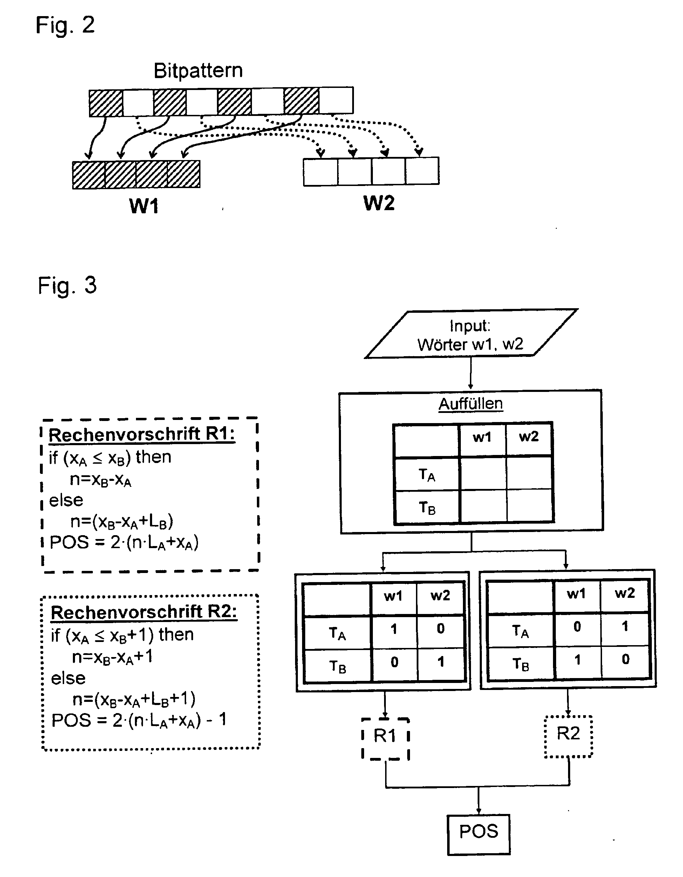

Zur Decodierung der Codewörter w weist die Decodiereinrichtung 3 zwei Tabellen $T_A$, $T_B$ auf, die Tabelle $T_A$ für die Codesequenz A und die Tabelle $T_B$ für die Codesequenz B. Eine bestimmte Anzahl von Codeelementen wird zur Generierung der Codewörter w mittels der Detektoranordnung 2 abgetastet. Die Anzahl der abgetasteten Codeelemente beider Codesequenzen A, B wird Abtastlänge $L_L$ bezeichnet und ist vorzugsweise eine gerade Anzahl von Codeelementen bzw. Bits. Die von der Detektoranordnung 2 generierte Bitfolge (Bitpattern) wird in zwei Wörter $w_1$ und $w_2$ aufgeschlüsselt, wie in Figur 2 dargestellt ist. Zur Dekodierung werden beide Wörter $w_1$ und $w_2$ in beiden Tabellen $T_A$;$T_B$ der Decodiereinrichtung 3 gesucht:

$w_1 \rightarrow T_A$; $w_1 \rightarrow T_B$; $W_2 \rightarrow T_A$; $w_2 \rightarrow T_B$
um eine Zuordnung zu erreichen:
$w_1 \rightarrow w_A$ bzw. $w_1 \rightarrow w_B$ und $w_2 \rightarrow w_A$ bzw. $w_2 \rightarrow w_B$

Bei der Suche gibt es folgende Möglichkeiten:

| Positionen | Decodierung |
|---|---|
| Gerade Positionen (0,2,4...) | $X_A=T_A(w_1)$ |
| | $X_B=T_B(w_2)$ |

(fortgesetzt)

| Positionen | Decodierung |
|---|---|
| Ungerade Positionen (1,3,5,...) | $X_A=T_A(w_2)$ |
| | $X_B=T_B(w_1)$ |

Dabei gilt:

- $w_1$, $w_2$ sind die von der Winkelcodierung 1 gelesenen Wörter w
- $x_A$, $x_B$ sind Teilpositionen innerhalb der Codesequenzen A bzw. B, also innerhalb der Tabelle $T_A$ bzw. $T_B$
- die Decodierung ist die Ermittlung von Positionen $x_A$, $x_B$ aus den Wörtern $w_1$, $w_2$

Bei diesem ersten Ausführungsbeispiel sind die beiden Codesequenzen A, B jeweils $N_A$ bzw. $N_B$ mal innerhalb 360° angeordnet, mit $N_A$ und $N_B$ ganzzahlig. An jede Codesequenz A, B schließt sich der Anfang dieser Codesequenz A, B wieder an, so dass an jeder Nahtstelle der aufeinanderfolgenden Codesequenzen A, B diese Codesequenz A, B zyklisch fortgesetzt ist.

Das in Figur 3 dargestellte Flussdiagramm sowie die dazu angegebenen Rechenvorschriften beschreiben die Berechnung der Gesamtposition POS aus den Positionen $x_A$, $x_B$. Wie die Figur 1 schematisch zeigt, sind die Rechenvorschriften R1, R2 in der Decodiereinrichtung 3 implementiert, um mittels der aus den Tabellen $T_A$ bzw. $T_B$ gewonnenen Teilpositionen $x_A$, $x_B$ die Gesamtposition POS zu ermitteln.

Mit der in Figur 1 beispielhaft dargestellten Winkelcodierung 1 ergibt sich somit:

Länge der Codesequenz A: $L_A = 5$
Codesequenz A: $A_0A_1A_2A_3A_4$
Länge der Codesequenz B: $L_B = 4$
Codesequenz B: $B_0B_1B_2B_3$
Abtastlänge: $L_L = 8$
$M_{1max}=2*L_A*L_B=40$
KGV $(L_A, L_B) = 20$
$N_A$ = KGV $(L_A, L_B) / L_A = 4$
$N_B=KGV(L_A, L_B)/L_B=5$

Die Tabelle $T_A$ für die Codesequenz A:

| Bitpattern | Wort w | Teilposition $x_A$ |
|---|---|---|
| $A_0A_1A_2A_3$ | $W_{A0}$ | 0 |
| $A_1A_2A_3A_4$ | $W_{A1}$ | 1 |
| $A_2A_3A_4A_0$ | $W_{A2}$ | 2 |
| $A_3A_4A_0A_1$ | $W_{A3}$ | 3 |
| $A_4A_0A_1A_2$ | $W_{A4}$ | 4 |

Die Tabelle $T_B$ für die Codesequenz B:

| Bitpattern | Wort w | Teilposition $x_B$ |
|------------|--------|--------------------|
| $B_0B_1B_2B_3$ | $W_{B0}$ | 0 |
| $B_1B_2B_3B_0$ | $W_{B1}$ | 1 |
| $B_2B_3B_0B_1$ | $W_{B2}$ | 2 |
| $B_3B_0B_1B_2$ | $W_{B3}$ | 3 |

Diese beiden Tabellen $T_A$, $T_B$ beinhalten zusammen 9 Einträge, mit diesen 9 Einträgen sind 40 verschiedene Positionen eindeutig decodierbar, und zwar über 360° in Winkelschritten entsprechend einer Breite eines Codeelementes. Voraussetzung für eine derartige Decodierung ist, dass jede der beiden Codesequenzen A, B über 360° mehrfach vollständig angeordnet ist, d. h. am Ende einer Codesequenz A, B diese Codesequenz A, B wieder beginnt und vollständig bis zum Anfang der nächsten Codesequenz A, B angeordnet ist.

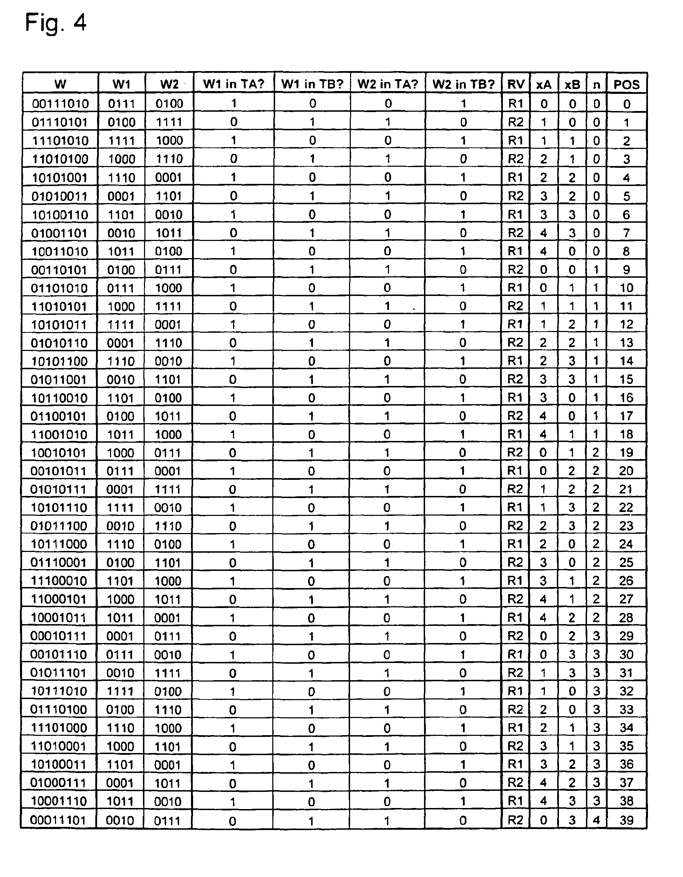

In Figur 4 ist ein Diagramm zur Ermittlung der Position POS aus gelesenen Bitpattern (Wörtern) w anhand des Beispiels der ersten Winkelcodierung 1 dargestellt. In der zweiten und dritten Spalte sind die aus den Wörtern w nach Figur 2 ermittelten Wörter w1 und w2 dargestellt. Die fünf weiteren Spalten zeigen die Abfrage, ob die Wörter w1 bzw. w2 in den Tabellen $T_A$ bzw. $T_B$ gefunden werden. Eine "1" definiert dabei gefunden. Die nächste mit "RV" bezeichnete Spalte definiert die zu verwendende Rechenvorschrift R1 bzw. R2. In den folgenden zwei Spalten sind die Teilpositionen $x_A$ und $x_B$ angegeben. Die nächste Spalte enthält den nach den in Figur 3 angegebenen Vorschriften berechneten Wert "n". Die letzte Spalte enthält nun die nach den entsprechenden Rechenvorschriften R1 bzw. R2 errechnete Position POS.

Soll der durch die beiden Codesequenzen A, B ermittelte Positionsmesswert weiter aufgelöst werden, kann die oben beschriebene Winkelcodierung 1 durch eine weitere Spur oder mehrere weitere Spuren mit absoluten Codierungen oder mit Inkrementalteilungen ergänzt sein.

Vorteilhaft kann es auch sein, aus der absoluten Winkelcodierung 1 zusätzlich ein periodisches Inkrementalsignal abzuleiten.

Ein Beispiel einer vorteilhaften Anordnung einer zusätzlichen Inkrementalspur 4 ist in Figur 1 dargestellt. Dabei ist parallel, also konzentrisch, zu der Spur mit den Codesequenzen A, B eine Inkrementalspur 4 vorgesehen. Die Teilungsperiode dieser Inkrementalspur 4 ist beispielsweise ein Bruchteil der Breite eines Codeelementes der Codesequenzen A, B und die Grenzen der Codeelemente fluchten mit Grenzen der Teilungsperioden der Inkrementalspur 4. Innerhalb eines Winkelsektors eines Codeelementes ist somit eine ganze Zahl, in vorteilhafter Weise größer 1, Inkrementalteilungsperioden angeordnet. Durch diese Dimensionierung der Inkrementalspur 4 ist es möglich, die Breite eines Codeelementes weiter zu unterteilen. Hierzu wird die Inkrementalteilung 4 mittels einer weiteren, nicht dargestellten, Detektoreinheit abgetastet, die in bekannter Weise mehrere gegeneinander phasenverschobene Inkrementalsignale erzeugt. Diese Inkrementalsignale werden einer Interpolationseinheit zugeführt, welche die Inkrementalsignale weiter unterteilt und eine absolute Teilposition innerhalb der Breite eines Codeelementes ausgibt. Die aus der absoluten Winkelcodierung 1 gewonnene absolute Position POS und die aus der Inkrementalspur 4 gewonnene Teilposition werden einer Kombinationseinheit zugeführt, welche daraus eine Gesamtposition bildet, die über den Messbereich von 360° absolut und damit eindeutig ist und eine Auflösung entsprechend dem aus der Inkrementalteilung ermittelten Interpolationsschritt aufweist.

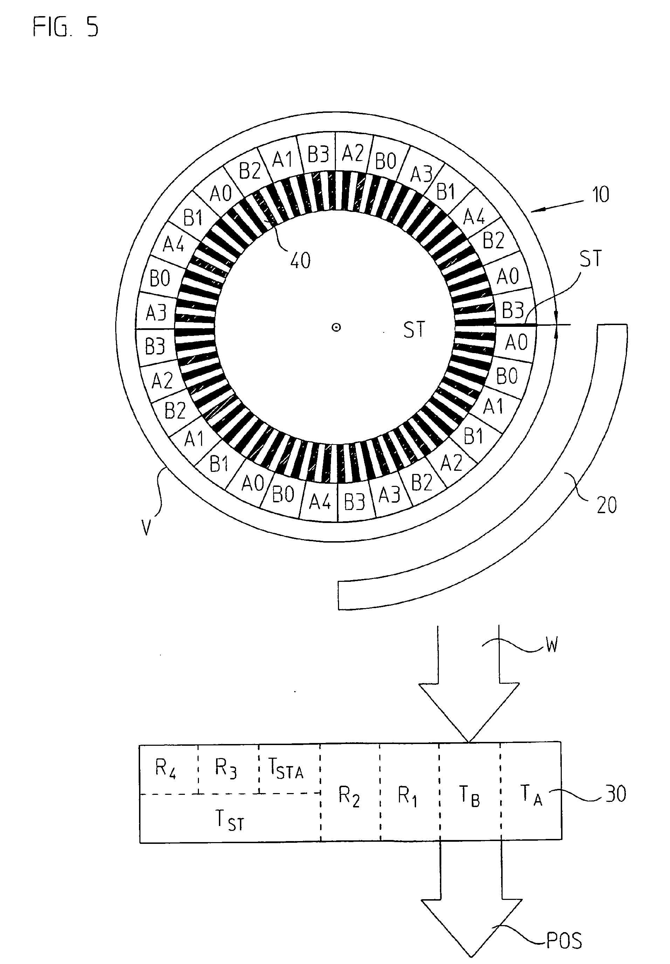

Für viele Anwendungen wird nun aber eine Winkelcodierung gewünscht, die über eine Umdrehung, also innerhalb 360°, $M_2 = 2^k$ unterschiedliche Positionen definiert. Nachfolgend wird nun anhand der Figuren 5 bis 7 ein zweites Ausführungsbeispiel der Erfindung beschrieben, bei dem zur Bildung einer Winkelcodierung 10 zumindest eine der Codesequenzen A, B innerhalb der 360° deshalb einmalig nicht vollständig ausgebildet ist, um die geforderten $M_2 = 2^k$ unterschiedlichen Positionen zu definieren. Die Winkelcodierung 10 ist wiederum gegeben durch die Längen $L_A$ und $L_B$ der Codesequenzen A und B, wobei $L_A \neq L_B$ und $L_A$ und $L_B$ ganzzahlig. Damit ist es nicht möglich $L_A$ und $L_B$ so zu wählen, dass $M_2 = 2 * KGV (L_A, L_B) = 2^k$, mit k>0 und ganzzahlig. Um dies zu erreichen, wird nun aus der beim ersten Beispiel beschriebenen Winkelcodierung 1 der maximalen Länge $M_{1max}$ nur ein Bereich V der Länge $M_2 = 2^k$ übernommen.

Gegeben sei nun weiterhin eine Detektoranordnung 20 mit einer Abtastlänge $L_L$, wobei $L_L$ geradzahlig. Für dieses System gibt es nun zwei Bereiche:

1. Bereich: Positionen 0... bis $(M_2 - L_L)$:

Dies ist der Bereich, in dem für die Winkelcodierung 10 der aus der Winkelcodierung 1 übernommene Bereich V vorliegt, und in dem die Gesamtposition POS mittels der Rechenvorschriften $R_1$ und $R_2$ des ersten Ausführungsbeispiels berechnet werden kann.

2. Bereich: Positionen $(M_2 - L_L + 1)$... bis $(M_2 - 1)$:

Durch Zusammenfügen des übernommenen Bereichs V ergibt sich eine neue Stoßstelle ST, an der zumindest eine der Codesequenzen A, B bzw. die zyklische Fortsetzung zumindest einer der Codesequenzen (hier die Codesequenz A) unterbrochen ist. Dieser Bereich über diese Stoßstelle ST bedingt eine gesonderte Behandlung mit zumindest einem zusätzlichen Wertevorrat zur Decodierung von Bitpattern, also einer gesonderten Tabelle, weil die bei der Abtastung generierten Bitpattern über diese Stoßstelle ST nicht in den Tabellen $T_A$ und/oder $T_B$ vorhanden sind.

Anhand eines Beispiels erfolgen nachfolgend weitere Erläuterungen:

Anzahl der benötigten Bits pro Umfang: $M_2 = 32 = 2^5$
Abtastlänge: $L_L = 8$
$L_A = 5$
$L_B = 4$

Die volle Winkelcodierung 1 hat eine Länge $= 2 * L_A * L_B = 40$ Positionen und wird zur Schaffung der benötigten Winkelcodierung 10 auf eine Länge $M_2$ von 32 Positionen abgeschnitten bzw. reduziert. In den Figuren 1 und 5 ist dieser reduzierte Bereich mit V bezeichnet.

Die Codesequenzen A bzw. B sind gegeben durch:

Codesequenz A: $A_0A_1A_2A_3A_4$
Codesequenz B: $B_0B_1B_2B_3$

Die Tabellen $T_A$ und $T_B$ sind dann gegeben durch:

Tabelle $T_A$: für Codesequenz A

| Bitpattern | Wort w | Teilposition $x_A$ |
|---|---|---|
| $A_0A_1A_2A_3$ | $W_{A0}$ | 0 |
| $A_1A_2A_3A_4$ | $W_{A1}$ | 1 |
| $A_2A_3A_4A_0$ | $W_{A2}$ | 2 |
| $A_3A_4A_0A_1$ | $W_{A3}$ | 3 |
| $A_4A_0A_1A_2$ | $W_{A4}$ | 4 |

Tabelle $T_B$: für Codesequenz B

| Bitpattern | Wort w | Teilposition $x_B$ |
|---|---|---|
| $B_0B_1B_2B_3$ | $W_{B0}$ | 0 |
| $B_1B_2B_3B_0$ | $W_{B1}$ | 1 |
| $B_2B_3B_0B_1$ | $W_{B2}$ | 2 |
| $B_3B_0B_1B_2$ | $W_{B3}$ | 3 |

Was passiert nun mit den Codesequenzen A und B an der neuen Stoßstelle ST?
Zunächst sieht man, dass die Codesequenz B genau an ihrer zyklischen Fortsetzung (also zwischen $B_3$ und $B_0$) abgeschnitten wurde. Bewegt sich die Detektoranordnung 20 also über die Stoßstelle ST hinweg, kommt es zu keinen Problemen mit der Codesequenz B ("B-Raster") und mit der Tabelle $T_B$: auf das Bit $B_3$ folgt wieder das Bit $B_0$. Die Codesequenz B sowie ihre zyklische Fortsetzung ist also nicht unterbrochen.

Dagegen ist die Codesequenz A an der Stoßstelle ST unterbrochen. Bei der Codesequenz A tauchen nun beim Überfahren der Stoßstelle ST mit der Detektoranordnung 20 neue Bitpattern auf, die in der Tabelle $T_A$ nicht vorkommen. Auf das Bit $A_0$ folgt eben nicht $A_1$, sondern wieder $A_0$ und dann erst $A_1$. Die neuen Positionen der Codesequenz A an der Stoßstelle ST sind in einer neuen Tabelle $T_{STA}$ ("ST" für Stoßstelle; "A" für die Codesequenz A) zusammengefasst.

Tabelle $T_{STA}$:

| Bitpattern | Wort w | Teilposition $x_{STA}$ |
|---|---|---|
| $A_3A_4A_0A_0$ | $W_{STA0}$ | 0 |
| $A_4A_0A_0A_1$ | $W_{STA1}$ | 1 |
| $A_0A_0A_1A_2$ | $W_{STA2}$ | 2 |

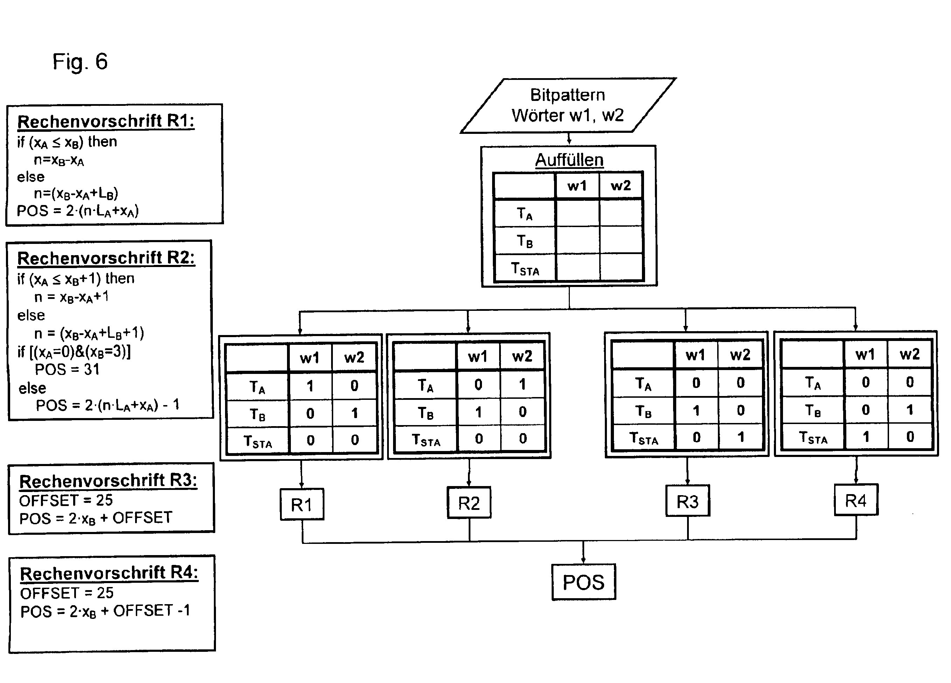

$POS_{ST}$ kann nun mittels der Tabellen $T_B$ sowie $T_{STA}$ ermittelt werden. Die dazugehörigen Rechenvorschriften R3 und R4 sind in Figur 6 angegeben. Es ist anzumerken, dass diese Rechenvorschriften R3 und R4 nur beispielhaft angegeben sind, da hier auch andere Beziehungen angesetzt werden können. Die Rechenvorschriften R1 und R2 entsprechen den Rechenvorschriften R1 und R2 des ersten Ausführungsbeispiels (Figur 3) mit der Sonderbehandlung für die Position 31.

Eine andere Möglichkeit zur Ermittlung der Positionen $POS_{ST}$ an der Stoßstelle ST besteht darin, dass die aufeinanderfolgenden Bitpattern in ihrer Gesamtheit betrachtet werden und am Stoß ST nicht in die beiden Codesequenzen A und B aufgeteilt werden. Hierzu werden die $(L_L-1) = 7$ Bitpattern des Stoßbereiches ST in eine Tabelle $T_{ST}$ geschrieben, wobei die Wortlänge in dieser Tabelle $T_{ST}$ nun $L_L$ ist, im Beispiel 8 ist.

Tabelle $T_{ST}$:

| Bitpattern | Wort w | Position $X_{ST}$ |
|---|---|---|
| $B_0A_3B_1A_4B_2A_0B_3A_0$ | $W_{ST0}$ | 25 |
| $A_3B_1A_4B_2A_0B_3A_0B_0$ | $W_{ST1}$ | 26 |
| $B_1A_4B_2A_0B_3A_0B_0A_1$ | $W_{ST2}$ | 27 |
| $A_4B_2A_0B_3A_0B_0A_1B$ | $W_{ST3}$ | 28 |
| $B_2A_0B_3A_0B_0A_1B_1A_2$ | $W_{ST4}$ | 29 |
| $A_0B_3A_0B_0A_1B_1A_2B_2$ | $W_{ST5}$ | 30 |
| $B_3A_0B_0B_1A_2B_2A_3$ | $W_{ST6}$ | 31 |

Abschließend sei für das obige Beispiel noch ein Code und die zugehörigen Tabellen angegeben:

Codesequenz A: 01111
Codesequenz B: 0100

Winkelcodierung 1 (Länge 40 Bits):

0011101010011010101100101011100010111010

Winkelcodierung 10 (Ausschnitt V von 32 Bits):

00111010100110101011001010111000

Tabelle $T_A$: für Codesequenz A

| Bitpattern | Wort w | Teilposition $x_A$ |
|---|---|---|
| 0111 | $W_{A0}$ | 0 |
| 1111 | $W_{A1}$ | 1 |
| 1110 | $W_{A2}$ | 2 |
| 1101 | $W_{A3}$ | 3 |
| 1011 | $W_{A4}$ | 4 |

Tabelle $T_B$: für Codesequenz B

| Bitpattern | Wort w | Teilposition $x_B$ |
|---|---|---|
| 0100 | $W_{B0}$ | 0 |
| 1000 | $W_{B1}$ | 1 |
| 0001 | $W_{B2}$ | 2 |
| 0010 | $W_{B3}$ | 3 |

Tabelle $T_{STA}$:

| Bitpattern | Wort w | Teilposition $x_{STA}$ |
|---|---|---|
| 1100 | $W_{STA0}$ | 0 |
| 1001 | $W_{STA1}$ | 1 |
| 0011 | $W_{STA2}$ | 2 |

Tabelle $T_{ST}$:

| Bitpattern | Wort w | Position $x_{ST}$ |
|---|---|---|
| 01110000 | $W_{ST0}$ | 25 |
| 11100000 | $W_{ST1}$ | 26 |
| 11000001 | $W_{ST2}$ | 27 |
| 10000011 | $W_{ST3}$ | 28 |
| 00000111 | $W_{ST4}$ | 29 |
| 00001110 | $W_{ST5}$ | 30 |
| 00011101 | $W_{ST6}$ | 31 |

Am Beispiel erkennt man, dass es besonders vorteilhaft ist, wenn eine der Codesequenzlängen ($L_A$ oder $L_B$) schon eine Zweierpotenz ist. Im obigen Beispiel ist die Gesamtlänge $M_2 = 32$ und $L_B = 4$. Der Vorteil hierbei ist dann, dass nur eine der Codesequenzen A oder B (hier nämlich nur Codesequenz A) "abgeschnitten" werden muss. Bei der anderen Codesequenz (hier die Codesequenz B) bleiben alle Codesequenzen sowie ihre zyklischen Fortsetzungen in der Gesamtheit über 360° vollständig erhalten.

Für die Anzahl der Codeelemente über 360° gilt:

$$M_2 = 2 * (KGV (L_A, L_B) - E * L_A)$$

was bedeutet, dass nur eine der Codesequenzen B innerhalb 360° unvollständig ist, alle Codesequenzen A aber vollständig aufgetragen und zyklisch fortgesetzt sind oder

$$M_2 = 2 * (KGV (L_A, L_B) - E * L_B)$$

was bedeutet, dass nur eine der Codesequenzen A innerhalb 360° unvollständig ist, alle Codesequenzen B aber vollständig aufgetragen und zyklisch fortgesetzt sind, mit E ganzzahlig > 0.

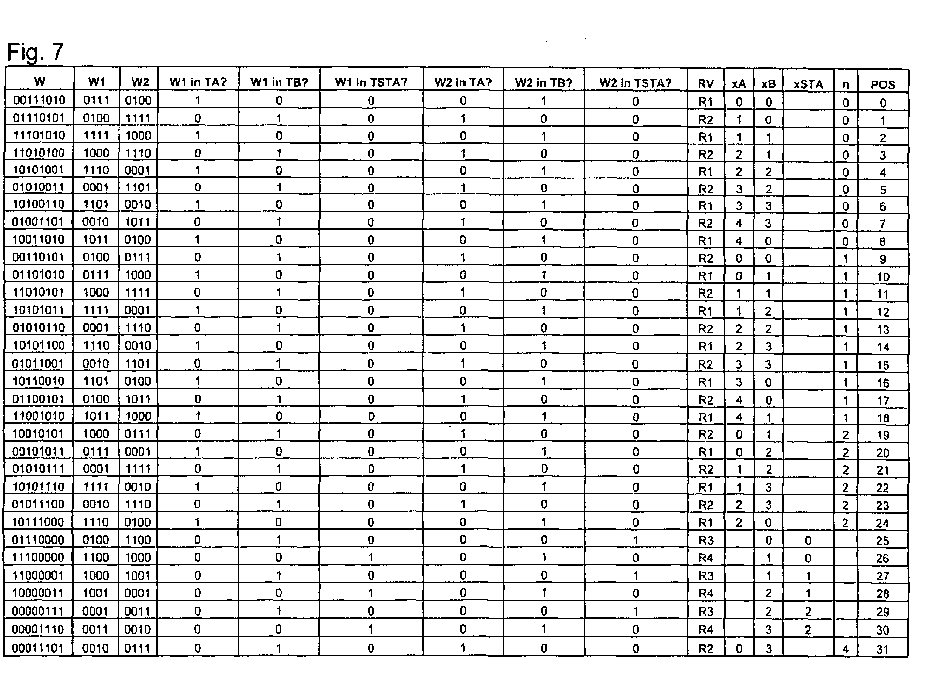

In Figur 7 ist ein Diagramm zur Ermittlung der Position POS aus gelesenen Bitpattern (Wörtern) w anhand des Beispiels der zweiten Winkelcodierung 10 dargestellt. In der zweiten und dritten Spalte sind die aus den Wörtern w nach Figur 2 ermittelten Wörter w1 und w2 dargestellt. Die sechs weiteren Spalten zeigen die Abfrage, ob die Wörter w1 bzw. w2 in den Tabellen $T_A$, $T_B$, $T_{STA}$ gefunden werden. Eine "1" definiert dabei gefunden. Die nächste mit "RV" bezeichnete Spalte definiert die zu verwendende Rechenvorschrift R1, R2, R3 bzw. R4. In den folgenden drei Spalten sind die Teilpositionen $x_A$, $x_B$ und $x_{STA}$ angegeben. Die nächste Spalte enthält den nach den in Figur 6 angegebenen Vorschriften berechneten Wert "n". Die letzte Spalte enthält nun die nach den entsprechenden Rechenvorschriften R1, R2, R3 bzw. R4 errechnete Position POS.

Die Decodiereinrichtung 3, 30 ist vorteilhaft als ASIC ausgebildet, wobei die erforderlichen Tabellen T, also die erforderlichen Wertevorräte, jeweils bei der Fertigung des ASIC's fest verdrahtet ausgebildet sind. Alternativ können die Tabellen T bzw. Wertevorräte aber auch in Festwertspeichern, wie EPROM abgelegt sein.

Bei der zweiten Winkelmessvorrichtung ist eine Mischform von Speichern besonders vorteilhaft, wobei einerseits ein schneller Zugriff auf die Speicherdaten, also die Wertevorräte, erreicht wird und andererseits auch eine schnelle Anpassung an den Anwendungszweck ermöglicht wird. Ausgeführt wird dies, indem einerseits der Wertevorrat $T_A$, $T_B$ für die Codesequenzen A und B sowie ihrer zyklischen Fortsetzungen fest verdrahtet ausgeführt ist und zusätzlich ein noch nach der Maskenherstellung programmierbarer Speicher vorgesehen wird, wobei in diesem programmierbaren Speicher der individuell erforderliche Wertevorrat $T_{ST}$, $T_{STA}$ des Stoßes ST eingespeichert wird, also die Tabellen $T_{ST}$ bzw. $T_{STA}$. Der programmierbare Speicher ist ein Festwertspeicher und ist beispielsweise als EPROM ausgebildet.

Wie in Figur 5 schematisch dargestellt, kann die absolute Winkelcodierung entsprechend dem Beispiel der Figur 1 durch eine Inkrementalteilung 40 ergänzt sein. Dabei ist wieder innerhalb eines Winkelsektors eines Codeelementes eine ganze Zahl, in vorteilhafter Weise größer 1, Inkrementalteilungsperioden angeordnet.

Die Erfindung ist beim optischen Abtastprinzip besonders vorteilhaft einsetzbar, da eine optisch abtastbare Winkelcodierung 1, 10 mit maximal möglich verschiedenen Positionen über 360° (eine Umdrehung der Winkelcodierung 1, 10) reproduzierbar herstellbar ist und damit eine besonders hochauflösende Positionsmessung ermöglicht wird. Dabei kann die Detektoranordnung 2, 20 und die Decodiereinrichtung 3, 30 gemeinsam in einem Opto-ASIC untergebracht sein.

Die Erfindung ist aber nicht auf das optische Abtastprinzip beschränkt, sondern auch bei magnetischen, induktiven sowie kapazitiven Abtastprinzipien einsetzbar.

**Patentansprüche**

1. Absolute Winkelmessvorrichtung mit
einer Winkelcodierung (1, 10) die mehrere innerhalb von 360° angeordnete Codesequenzen (A, B) aufweist, die in Kombination die 360° eindeutig absolut codieren, von denen eine erste Codesequenz (A) eine erste Länge ($L_A$) aufweist und $N_A$ mal aufeinanderfolgend angeordnet ist, und eine zweite Codesequenz (B) eine zweite Länge ($L_B$) aufweist und $N_B$ mal aufeinanderfolgend angeordnet ist, wobei $N_A$ größer gleich 2; $N_B$ größer gleich 2; $N_A$ ungleich $N_B$; die erste Länge $L_A$ ist ungleich der zweiten Länge $L_B$; und die erste Codesequenz (A) und die zweite Codesequenz (B) in einer gemeinsamen Spur angeordnet sind, indem jeweils ein Teil der ersten Codesequenz (A) und ein Teil der zweiten Codesequenz (B) abwechselnd angeordnet ist;
einer Detektoranordnung (2, 20) zur Abtastung der ersten und der zweiten Codesequenz (A, B) der Winkelcodierung (1, 10) und zur Generierung von jeweils eines ersten Codewortes (w), das bei der Abtastung einer der ersten Codesequenzen (A) sowie ihrer zyklischen Fortsetzung entsteht, und eines zweiten Codewortes (w), das bei der Abtastung einer der zweiten Codesequenzen (B) sowie ihrer zyklischen Fortsetzung entsteht, und
einer Dekodiereinrichtung (3, 30) zur Dekodierung des ersten Codewortes (w) und des zweiten Codewortes (w) und zur Generierung eines Positionswertes (POS) daraus, wobei über 360° mehrere unterschiedliche Positionswerte (POS) generierbar sind.

2. Absolute Winkelmessvorrichtung nach Anspruch 1, **dadurch gekennzeichnet, dass** die erste Länge ($L_A$) der ersten Codesequenz (A) kein ganzzahliges Vielfaches der zweiten Länge ($L_B$) der zweiten Codesequenz (B) ist.

3. Absolute Winkelmessvorrichtung nach Anspruch 2, **dadurch gekennzeichnet, dass** sich die Länge ($L_A$) der ersten Codesequenz (A) von der Länge ($L_B$) der zweiten Codesequenz (B) um 1 unterscheidet.

4. Absolute Winkelmessvorrichtung nach einem der vorhergehenden Ansprüche, **dadurch gekennzeichnet, dass** $N_A$ und $N_B$ ganzzahlig.

5. Absolute Winkelmessvorrichtung nach Anspruch 4, **dadurch gekennzeichnet, dass** abwechselnd ein Codeelement der ersten Codesequenz (A) und ein Codeelement der zweiten Codesequenz (B) angeordnet ist, und über 360° eine Anzahl $M_1 = 2 * KGV$ ($L_A$, $L_B$) Codeelemente angeordnet ist, mit
KGV ($L_A$, $L_B$) = kleinstes gemeinsames Vielfaches von $L_A$ und $L_B$
$L_A$ = Länge der ersten Codesequenz (A);
$L_B$ = Länge der zweiten Codesequenz (B).

6. Absolute Winkelmessvorrichtung nach Anspruch 5, **dadurch gekennzeichnet, dass** über 360° eine Anzahl $M_1 = 2 * L_A * L_B$ Codeelemente angeordnet ist, mit
$L_A$ = Länge der ersten Codesequenz (A);
$L_B$ = Länge der zweiten Codesequenz (B).

7. Absolute Winkelmessvorrichtung nach einem der vorhergehenden Ansprüche 1 bis 3, **dadurch gekennzeichnet, dass** über 360° eine Anzahl
$M_2 < 2 * KGV$ ($L_A$, $L_B$) Codeelemente angeordnet ist, mit
KGV ($L_A$, $L_B$) = kleinstes gemeinsames Vielfaches von $L_A$ und $L_B$
$L_A$ = Länge der ersten Codesequenz (A)
$L_B$ = Länge der zweiten Codesequenz (B).

8. Absolute Winkelmessvorrichtung nach Anspruch 7, **dadurch gekennzeichnet, dass** über 360° eine Anzahl $M_2 = 2 * (KGV (L_A, L_B) - E * L_A)$ angeordnet ist, oder
eine Anzahl $M_2 = 2 * (KGV (L_A, L_B) - E * L_B)$ angeordnet ist,
mit E ganzzahlig > 0.

9. Absolute Winkelcodierung nach Anspruch 7 oder 8, **dadurch gekennzeichnet, dass** über 360° $M_2 = 2^k$ Codeelemente angeordnet sind, mit k>4 und ganzzahlig.

10. Absolute Winkelmessvorrichtung nach einem der vorhergehenden Ansprüche, **dadurch gekenn-**

**zeichnet, dass** konzentrisch zu der absoluten Winkelcodierung (1, 10) zumindest eine Inkrementalspur (4, 40) angeordnet ist und innerhalb eines Codeelementes eine ganze Zahl Inkrementalteilungsperioden angeordnet ist.

11. Absolute Winkelmessvorrichtung nach Anspruch 10, **dadurch gekennzeichnet, dass** konzentrisch zu der absoluten Winkelcodierung (1, 10) eine einzige Inkrementalspur (4, 40) angeordnet ist und innerhalb eines Codeelementes eine ganze Zahl größer 1 Inkrementalteilungsperioden angeordnet ist.

12. Absolute Winkelmessvorrichtung nach einem der Ansprüche 1 bis 11, **dadurch gekennzeichnet, dass** die Dekodiereinrichtung (3, 30) einen ersten Wertevorrat ($T_A$) zur Dekodierung einer ersten Folge von Codewörtern (w) aufweist, die jeweils bei der Abtastung einer der ersten Codesequenzen (A) sowie ihrer zyklischen Fortsetzung entsteht, und die Dekodiereinrichtung (3, 30) einen zweiten Wertevorrat ($T_B$) zur Dekodierung einer zweiten Folge von Codewörtern (w) aufweist, die jeweils bei der Abtastung einer der zweiten Codesequenzen (B) sowie ihrer zyklischen Fortsetzung entsteht.

13. Absolute Winkelmessvorrichtung nach einem der Ansprüche 7 bis 9 **dadurch gekennzeichnet, dass** die Dekodiereinrichtung (30) einen ersten Wertevorrat ($T_A$) zur Dekodierung einer ersten Folge von Codewörtern (w) aufweist, die jeweils bei der Abtastung einer der ersten Codesequenzen (A) sowie ihrer zyklischen Fortsetzung entsteht, und die Dekodiereinrichtung (30) einen zweiten Wertevorrat ($T_B$) zur Dekodierung einer zweiten Folge von Codewörtern (w) aufweist, die jeweils bei der Abtastung einer der zweiten Codesequenzen (B) sowie ihrer zyklischen Fortsetzung entsteht, und die Decodiereinrichtung (30) einen weiteren Wertevorrat ($T_{STA}$, $T_{ST}$) aufweist, der zur Decodierung einer Unterbrechung (ST) der ersten Codesequenz (A) und / oder der zweiten Codesequenz (B) geeignet ist.

14. Absolute Winkelmessvorrichtung nach Anspruch 13, **dadurch gekennzeichnet, dass** der weitere Wertevorrat ($T_{STA}$, $T_{ST}$) in einem programmierbaren Festwertspeicher abgespeichert ist und der erste Wertevorrat ($T_A$) sowie der zweite Wertevorrat ($T_B$) fest verdrahtet vorliegt.

**Claims**

1. Absolute angle measuring device having
an angle coding (1, 10) having a plurality of code sequences (A, B) which are arranged within 360° and, in combination, unambiguously code the 360° in absolute terms, a first code sequence (A) of which has a first length ($L_A$) and is arranged $N_A$ times in succession, and a second code sequence (B) of which has a second length ($L_B$) and is arranged $N_B$ times in succession, where $N_A$ is greater than or equal to 2; $N_B$ is greater than or equal to 2; $N_A$ is not equal to $N_B$;
the first length $L_A$ is not equal to the second length $L_B$; and the first code sequence (A) and the second code sequence (B) are arranged in a common track by virtue of a part of the first code sequence (A) and a part of the second code sequence (B) respectively being alternately arranged;
a detector arrangement (2, 20) for scanning the first and second code sequences (A, B) of the angle coding (1, 10) and for respectively generating a first code word (w), which is produced when scanning one of the first code sequences (A) and the cyclical continuation thereof, and a second code word (w) which is produced when scanning one of the second code sequences (B) and the cyclical continuation thereof, and
a decoding device (3, 30) for decoding the first code word (w) and the second code word (w) and for generating a position value (POS) therefrom, a plurality of different position values (POS) being able to be generated over 360°.

2. Absolute angle measuring device according to Claim 1, **characterized in that** the first length ($L_A$) of the first code sequence (A) is not an integer multiple of the second length ($L_B$) of the second code sequence (B).

3. Absolute angle measuring device according to Claim 2, **characterized in that** the length ($L_A$) of the first code sequence (A) differs from the length ($L_B$) of the second code sequence (B) by 1.

4. Absolute angle measuring device according to one of the preceding claims, **characterized in that** $N_A$ and $N_B$ are integers.

5. Absolute angle measuring device according to Claim 4, **characterized in that** a code element of the first code sequence (A) and a code element of the second code sequence (B) are alternately arranged, and a number $M_1 = 2 * KGV (L_A, L_B)$ of code elements is arranged over 360°, where
$KGV (L_A, L_B)$ = least common multiple of $L_A$ and $L_B$
$L_A$ = length of the first code sequence (A);
$L_B$ = length of the second code sequence (B).

6. Absolute angle measuring device according to Claim 5, **characterized in that** a number $M_1 = 2 * L_A * L_B$ of code elements is arranged over 360°, where
$L_A$ = length of the first code sequence (A);
$L_B$ = length of the second code sequence (B).

7. Absolute angle measuring device according to one of the preceding Claims 1 to 3, **characterized in that** a number $M_2 < 2 * KGV (L_A, L_B)$ of code elements is arranged over 360°, where

   KGV $(L_A, L_B)$ = least common multiple of $L_A$ and $L_B$
   $L_A$ = length of the first code sequence (A)
   $L_B$ = length of the second code sequence (B).

8. Absolute angle measuring device according to Claim 7, **characterized in that** a number $M_2 = 2 * (KGV (L_A, L_B) - E * L_A)$ is arranged over 360°, or
   a number $M2 = 2 * (KGV (L_A, L_B) - E * L_B)$ is arranged, where E is an integer > 0.

9. Absolute angle measuring device according to Claim 7 or 8, **characterized in that** $M_2 = 2^k$ code elements are arranged over 360°, where k>4 and is an integer.

10. Absolute angle measuring device according to one of the preceding claims, **characterized in that** at least one incremental track (4, 40) is arranged concentrically with respect to the absolute angle coding (1, 10), and a whole number of incremental graduation periods is arranged inside a code element.

11. Absolute angle measuring device according to Claim 10, **characterized in that** a single incremental track (4, 40) is arranged concentrically with respect to the absolute angle coding (1, 10), and a whole number of greater than 1 incremental graduation period is arranged inside a code element.

12. Absolute angle measuring device according to one of Claims 1 to 11, **characterized in that** the decoding device (3, 30) has a first set of values $(T_A)$ for decoding a first sequence of code words (w) which is respectively produced when scanning one of the first code sequences (A) and the cyclical continuation thereof, and
   the decoding device (3, 30) has a second set of values $(T_B)$ for decoding a second sequence of code words (w) which is respectively produced when scanning one of the second code sequences (B) and the cyclical continuation thereof.

13. Absolute angle measuring device according to one of Claims 7 to 9, **characterized in that** the decoding device (30) has a first set of values $(T_A)$ for decoding a first sequence of code words (w) which is respectively produced when scanning one of the first code sequences (A) and the cyclical continuation thereof, and
   the decoding device (30) has a second set of values $(T_B)$ for decoding a second sequence of code words (w) which is respectively produced when scanning one of the second code sequences (B) and the cyclical continuation thereof, and
   the decoding device (30) has a further set of values $(T_{STA}, T_{ST})$ which is suitable for decoding an interruption (ST) in the first code sequence (A) and/or the second code sequence (B).

14. Absolute angle measuring device according to Claim 13, **characterized in that** the further set of values $(T_{STA}, T_{ST})$ is stored in a programmable read-only memory, and the first set of values $(T_A)$ and the second set of values $(T_B)$ are hard-wired.

## Revendications

1. Dispositif de mesure absolue d'angles avec
   un codage angulaire (1, 10) comportant plusieurs séquences de codes (A, B) disposées sur 360°, qui en combinaison codent en absolu de manière univoque les 360°, dont une première séquence de codes (A) présente une première longueur $(L_A)$ et est disposée successivement $N_A$ fois, et une deuxième séquence de codes (B) présente une deuxième longueur $(L_B)$ et est disposée successivement $N_B$ fois, dans lequel
   $N_A$ est supérieur ou égal à 2 ; $N_B$ supérieur ou égal à 2 ; $N_A$ différent de $N_B$ ;
   la première longueur $L_A$ est différente de la deuxième longueur $L_B$ ;
   et la première séquence de codes (A) et la deuxième séquence de codes (B) sont disposées sur une piste commune, en disposant alternativement respectivement une partie de la première séquence de codes (A) et une partie de la deuxième séquence de codes (B) ;
   un arrangement de détecteurs (2, 20) pour l'exploration de la première et de la deuxième séquence de codes (A, B) du codage angulaire (1, 10) et pour la génération respectivement d'un premier mot de code (w), formé lors de l'exploration d'une des premières séquences de codes (A) ainsi que de sa répétition cyclique, et d'un deuxième mot de code (w), formé lors de l'exploration d'une des deuxièmes séquences- de codes (B) ainsi que de sa répétition cyclique, et
   un appareillage de décodage (3, 30) pour le décodage du premier mot de code (w) et du deuxième mot de code (w) et pour la génération qui en découle d'une valeur de position (POS), plusieurs valeurs de position (POS) différentes pouvant être générées sur 360°.

2. Dispositif de mesure absolue d'angles selon la revendication 1, **caractérisé en ce que** la première longueur $(L_A)$ de la première séquence de codes (A) n'est pas un multiple entier de la deuxième longueur $(L_B)$ de la deuxième séquence de codes (B).

3. Dispositif de mesure absolue d'angles selon la revendication 2, **caractérisé en ce que** la longueur

($L_A$) de la première séquence de codes (A) diffère de 1 de la deuxième longueur ($L_B$) de la deuxième séquence de codes (B).

4. Dispositif de mesure absolue d'angles selon une des revendications précédentes, **caractérisé en ce que** $N_A$ et $N_B$ sont des nombres entiers.

5. Dispositif de mesure absolue d'angles selon la revendication 4, **caractérisé en ce qu'**un élément de code de la première séquence de codes (A) est disposé en alternance avec un élément de code de la deuxième séquence de codes (B), et sur 360° est disposé un nombre $M_1 = 2 * KGV (LA, L_B)$ d'éléments de code, avec

KGV ($L_A$, $L_B$) = plus petit commun multiple de $L_A$ et $L_B$

$L_A$ = longueur de la première séquence de codes (A) ;

$L_B$ = longueur de la deuxième séquence de codes (B).

6. Dispositif de mesure absolue d'angles selon la revendication 5, **caractérisé en ce que** sur 360° est disposé un nombre $M_1 = 2 * L_A * L_B$ d'éléments de code, avec

$L_A$ = longueur de la première séquence de codes (A) ;

$L_B$ = longueur de la deuxième séquence de codes (B).

7. Dispositif de mesure absolue d'angles selon une des revendications précédentes 1 à 3, **caractérisé en ce que** sur 360° est disposé un nombre

$M_2 < 2 * KGV (L_A, L_B)$ d'éléments de code, avec KGV($L_A$, $L_B$) = plus petit commun multiple de $L_A$ et $L_B$

$L_A$ = longueur de la première séquence de codes (A)

$L_B$ = longueur de la deuxième séquence de codes (B).

8. Dispositif de mesure absolue d'angles selon la revendication 7, **caractérisé en ce que** sur 360° est disposé un nombre

$M_2 = 2 * (KGV (L_A, L_B) - E * L_A)$ ou un nombre $M_2 = 2 * (KGV (L_A, L_B) - E * L_B)$, avec E nombre entier > 0.

9. Dispositif de mesure absolue d'angles selon la revendication 7 ou 8, **caractérisé en ce que** sur 360° sont disposés $M_2 = 2^k$ éléments de code, avec k > 4 et nombre entier.

10. Dispositif de mesure absolue d'angles selon une des revendications précédentes, **caractérisé en ce qu'**au moins une piste incrémentale (4, 40) est disposée concentriquement au codage angulaire absolu (1, 10) et **en ce qu'**un nombre entier de périodes de sections incrémentales est disposé à l'intérieur d'un élément de code.

11. Dispositif de mesure absolue d'angles selon la revendication 10, **caractérisé en ce qu'**une seule piste incrémentale (4, 40) est disposée concentriquement au codage angulaire absolu (1, 10) et **en ce qu'**un nombre entier supérieur à 1 de périodes de sections incrémentales est disposé à l'intérieur d'un élément de code.

12. Dispositif de mesure absolue d'angles selon une des revendications 1 à 11, **caractérisé en ce que** l'appareillage de décodage (3, 30) comporte un premier stock de valeurs ($T_A$) pour le décodage d'une première succession de mots de code (w), qui est respectivement créée lors de l'exploration d'une des premières séquences de codes (A) ainsi que de leur succession cyclique, et **en ce que** l'appareillage de décodage (3, 30) comporte un deuxième stock de valeurs ($T_B$) pour le décodage d'une deuxième succession de mots de code (w), qui est respectivement créée lors de l'exploration d'une des deuxièmes séquences de codes (B) ainsi que de leur succession cyclique.

13. Dispositif de mesure absolue d'angles selon une des revendications 7 à 9, **caractérisé en ce que** l'appareillage de décodage (30) comporte un premier stock de valeurs ($T_A$) pour le décodage d'une première succession de mots de code (w), qui est respectivement créée lors de l'exploration d'une des premières séquences de codes (A) ainsi que de leur succession cyclique, et **en ce que** l'appareillage de décodage (30) comporte un deuxième stock de valeurs ($T_B$) pour le décodage d'une deuxième succession de mots de code (w), qui est respectivement créée lors de l'exploration d'une des deuxièmes séquences de codes (B) ainsi que de leur succession cyclique, et **en ce que**

l'appareillage de décodage (30) comporte un stock supplémentaire de valeurs ($T_{STA}$, $T_{ST}$) apte au décodage d'une interruption (ST) de la première séquence de codes (A) et/ou de la deuxième séquence de codes (B).

14. Dispositif de mesure absolue d'angles selon la revendication 13, **caractérisé en ce que** le stock supplémentaire de valeurs ($T_{STA}$, $T_{ST}$) est stocké dans une mémoire permanente programmable et le premier stock de valeurs ($T_A$) ainsi que le deuxième stock de valeurs ($T_B$) sont disponibles sous forme câblée.

FIG. 1

# Fig. 2

Bitpattern

**W1**             **W2**

# Fig. 3

**Rechenvorschrift R1:**
if $(x_A \leq x_B)$ then
    $n = x_B - x_A$
else
    $n = (x_B - x_A + L_B)$
POS $= 2 \cdot (n \cdot L_A + x_A)$

**Rechenvorschrift R2:**
if $(x_A \leq x_B + 1)$ then
    $n = x_B - x_A + 1$
else
    $n = (x_B - x_A + L_B + 1)$
POS $= 2 \cdot (n \cdot L_A + x_A) - 1$

Input:
Wörter w1, w2

Auffüllen

|       | w1 | w2 |
|-------|----|----|
| $T_A$ |    |    |
| $T_B$ |    |    |

|       | w1 | w2 |
|-------|----|----|
| $T_A$ | 1  | 0  |
| $T_B$ | 0  | 1  |

|       | w1 | w2 |
|-------|----|----|
| $T_A$ | 0  | 1  |
| $T_B$ | 1  | 0  |

R1          R2

POS

# Fig. 4

| W | W1 | W2 | W1 in TA? | W1 in TB? | W2 in TA? | W2 in TB? | RV | xA | xB | n | POS |
|---|---|---|---|---|---|---|---|---|---|---|---|
| 00111010 | 0111 | 0100 | 1 | 0 | 0 | 1 | R1 | 0 | 0 | 0 | 0 |
| 01110101 | 0100 | 1111 | 0 | 1 | 1 | 0 | R2 | 1 | 0 | 0 | 1 |
| 11101010 | 1111 | 1000 | 1 | 0 | 0 | 1 | R1 | 1 | 1 | 0 | 2 |
| 11010100 | 1000 | 1110 | 0 | 1 | 1 | 0 | R2 | 2 | 1 | 0 | 3 |
| 10101001 | 1110 | 0001 | 1 | 0 | 0 | 1 | R1 | 2 | 2 | 0 | 4 |
| 01010011 | 0001 | 1101 | 0 | 1 | 1 | 0 | R2 | 3 | 2 | 0 | 5 |
| 10100110 | 1101 | 0010 | 1 | 0 | 0 | 1 | R1 | 3 | 3 | 0 | 6 |
| 01001101 | 0010 | 1011 | 0 | 1 | 1 | 0 | R2 | 4 | 3 | 0 | 7 |
| 10011010 | 1011 | 0100 | 1 | 0 | 0 | 1 | R1 | 4 | 0 | 0 | 8 |
| 00110101 | 0100 | 0111 | 0 | 1 | 1 | 0 | R2 | 0 | 0 | 1 | 9 |
| 01101010 | 0111 | 1000 | 1 | 0 | 0 | 1 | R1 | 0 | 1 | 1 | 10 |
| 11010101 | 1000 | 1111 | 0 | 1 | 1 | 0 | R2 | 1 | 1 | 1 | 11 |
| 10101011 | 1111 | 0001 | 1 | 0 | 0 | 1 | R1 | 1 | 2 | 1 | 12 |
| 01010110 | 0001 | 1110 | 0 | 1 | 1 | 0 | R2 | 2 | 2 | 1 | 13 |
| 10101100 | 1110 | 0010 | 1 | 0 | 0 | 1 | R1 | 2 | 3 | 1 | 14 |
| 01011001 | 0010 | 1101 | 0 | 1 | 1 | 0 | R2 | 3 | 3 | 1 | 15 |
| 10110010 | 1101 | 0100 | 1 | 0 | 0 | 1 | R1 | 3 | 0 | 1 | 16 |
| 01100101 | 0100 | 1011 | 0 | 1 | 1 | 0 | R2 | 4 | 0 | 1 | 17 |
| 11001010 | 1011 | 1000 | 1 | 0 | 0 | 1 | R1 | 4 | 1 | 1 | 18 |
| 10010101 | 1000 | 0111 | 0 | 1 | 1 | 0 | R2 | 0 | 1 | 2 | 19 |
| 00101011 | 0111 | 0001 | 1 | 0 | 0 | 1 | R1 | 0 | 2 | 2 | 20 |
| 01010111 | 0001 | 1111 | 0 | 1 | 1 | 0 | R2 | 1 | 2 | 2 | 21 |
| 10101110 | 1111 | 0010 | 1 | 0 | 0 | 1 | R1 | 1 | 3 | 2 | 22 |
| 01011100 | 0010 | 1110 | 0 | 1 | 1 | 0 | R2 | 2 | 3 | 2 | 23 |
| 10111000 | 1110 | 0100 | 1 | 0 | 0 | 1 | R1 | 2 | 0 | 2 | 24 |
| 01110001 | 0100 | 1101 | 0 | 1 | 1 | 0 | R2 | 3 | 0 | 2 | 25 |
| 11100010 | 1101 | 1000 | 1 | 0 | 0 | 1 | R1 | 3 | 1 | 2 | 26 |
| 11000101 | 1000 | 1011 | 0 | 1 | 1 | 0 | R2 | 4 | 1 | 2 | 27 |
| 10001011 | 1011 | 0001 | 1 | 0 | 0 | 1 | R1 | 4 | 2 | 2 | 28 |
| 00010111 | 0001 | 0111 | 0 | 1 | 1 | 0 | R2 | 0 | 2 | 3 | 29 |
| 00101110 | 0111 | 0010 | 1 | 0 | 0 | 1 | R1 | 0 | 3 | 3 | 30 |
| 01011101 | 0010 | 1111 | 0 | 1 | 1 | 0 | R2 | 1 | 3 | 3 | 31 |
| 10111010 | 1111 | 0100 | 1 | 0 | 0 | 1 | R1 | 1 | 0 | 3 | 32 |
| 01110100 | 0100 | 1110 | 0 | 1 | 1 | 0 | R2 | 2 | 0 | 3 | 33 |
| 11101000 | 1110 | 1000 | 1 | 0 | 0 | 1 | R1 | 2 | 1 | 3 | 34 |
| 11010001 | 1000 | 1101 | 0 | 1 | 1 | 0 | R2 | 3 | 1 | 3 | 35 |
| 10100011 | 1101 | 0001 | 1 | 0 | 0 | 1 | R1 | 3 | 2 | 3 | 36 |
| 01000111 | 0001 | 1011 | 0 | 1 | 1 | 0 | R2 | 4 | 2 | 3 | 37 |
| 10001110 | 1011 | 0010 | 1 | 0 | 0 | 1 | R1 | 4 | 3 | 3 | 38 |
| 00011101 | 0010 | 0111 | 0 | 1 | 1 | 0 | R2 | 0 | 3 | 4 | 39 |

FIG. 5

# Fig. 6

**Rechenvorschrift R1:**

if $(x_A \leq x_B)$ then
$\quad$ n=$x_B$-$x_A$
else
$\quad$ n=$(x_B$-$x_A$+$L_B)$
POS = $2 \cdot (n \cdot L_A + x_A)$

**Rechenvorschrift R2:**

if $(x_A \leq x_B+1)$ then
$\quad$ n = $x_B$-$x_A$+1
else
$\quad$ n = $(x_B$-$x_A$+$L_B$+1$)$
if $[(x_A=0)\&(x_B=3)]$
$\quad$ POS = 31
else
$\quad$ POS = $2 \cdot (n \cdot L_A + x_A)$ - 1

**Rechenvorschrift R3:**
OFFSET = 25
POS = $2 \cdot x_B$ + OFFSET

**Rechenvorschrift R4:**
OFFSET = 25
POS = $2 \cdot x_B$ + OFFSET -1

Bitpattern Wörter w1, w2

Auffüllen

|            | w1 | w2 |
|------------|----|----|
| $T_A$      |    |    |
| $T_B$      |    |    |
| $T_{STA}$  |    |    |

|            | w1 | w2 |
|------------|----|----|
| $T_A$      | 1  | 0  |
| $T_B$      | 0  | 1  |
| $T_{STA}$  | 0  | 0  |

R1

|            | w1 | w2 |
|------------|----|----|
| $T_A$      | 0  | 1  |
| $T_B$      | 1  | 0  |
| $T_{STA}$  | 0  | 0  |

R2

|            | w1 | w2 |
|------------|----|----|
| $T_A$      | 0  | 0  |
| $T_B$      | 1  | 0  |
| $T_{STA}$  | 0  | 1  |

R3

|            | w1 | w2 |
|------------|----|----|
| $T_A$      | 0  | 0  |
| $T_B$      | 0  | 1  |
| $T_{STA}$  | 1  | 0  |

R4

POS

Fig. 7

| W | W1 | W2 | W1 in TA? | W1 in TB? | W1 in TSTA? | W2 in TA? | W2 in TB? | W2 in TSTA? | RV | xA | xB | xSTA | n | POS |
|---|----|----|-----------|-----------|-------------|-----------|-----------|-------------|----|----|----|------|---|-----|
| 00111010 | 0111 | 0100 | 1 | 0 | 0 | 0 | 1 | 0 | R1 | 0 | 0 | | 0 | 0 |
| 01110101 | 0100 | 1111 | 0 | 1 | 0 | 1 | 0 | 0 | R2 | 1 | 0 | | 0 | 1 |
| 11101010 | 1111 | 1000 | 1 | 0 | 0 | 0 | 1 | 0 | R1 | 1 | 1 | | 0 | 2 |
| 11010100 | 1000 | 1110 | 0 | 1 | 0 | 1 | 0 | 0 | R2 | 2 | 1 | | 0 | 3 |
| 10101001 | 1110 | 0001 | 1 | 0 | 0 | 0 | 1 | 0 | R1 | 2 | 2 | | 0 | 4 |
| 01010011 | 0001 | 1101 | 0 | 1 | 0 | 1 | 0 | 0 | R2 | 3 | 2 | | 0 | 5 |
| 10100110 | 1101 | 0010 | 1 | 0 | 0 | 0 | 1 | 0 | R1 | 3 | 3 | | 0 | 6 |
| 01001101 | 0010 | 1011 | 0 | 1 | 0 | 1 | 0 | 0 | R2 | 4 | 3 | | 0 | 7 |
| 10011010 | 1011 | 0100 | 1 | 0 | 0 | 0 | 1 | 0 | R1 | 4 | 0 | | 0 | 8 |
| 00110101 | 0100 | 0111 | 0 | 1 | 0 | 1 | 0 | 0 | R2 | 0 | 0 | | 1 | 9 |
| 01101010 | 0111 | 1000 | 1 | 0 | 0 | 0 | 1 | 0 | R1 | 0 | 1 | | 1 | 10 |
| 11010101 | 1000 | 1111 | 0 | 1 | 0 | 1 | 0 | 0 | R2 | 1 | 1 | | 1 | 11 |
| 10101011 | 1111 | 0001 | 1 | 0 | 0 | 0 | 1 | 0 | R1 | 1 | 2 | | 1 | 12 |
| 01010110 | 0001 | 1110 | 0 | 1 | 0 | 1 | 0 | 0 | R2 | 2 | 2 | | 1 | 13 |
| 10101100 | 1110 | 0010 | 1 | 0 | 0 | 0 | 1 | 0 | R1 | 2 | 3 | | 1 | 14 |
| 01011001 | 0010 | 1101 | 0 | 1 | 0 | 1 | 0 | 0 | R2 | 3 | 3 | | 1 | 15 |
| 10110010 | 1101 | 0100 | 1 | 0 | 0 | 0 | 1 | 0 | R1 | 3 | 0 | | 1 | 16 |
| 01100101 | 0100 | 1011 | 0 | 1 | 0 | 1 | 0 | 0 | R2 | 4 | 0 | | 1 | 17 |
| 11001010 | 1011 | 1000 | 1 | 0 | 0 | 0 | 1 | 0 | R1 | 4 | 1 | | 1 | 18 |
| 10010101 | 1000 | 0111 | 0 | 1 | 0 | 1 | 0 | 0 | R2 | 0 | 1 | | 2 | 19 |
| 00101011 | 0111 | 0001 | 1 | 0 | 0 | 0 | 1 | 0 | R1 | 0 | 2 | | 2 | 20 |
| 01010111 | 0001 | 1111 | 0 | 1 | 0 | 1 | 0 | 0 | R2 | 1 | 2 | | 2 | 21 |
| 10101110 | 1111 | 0010 | 1 | 0 | 0 | 0 | 1 | 0 | R1 | 1 | 3 | | 2 | 22 |
| 01011100 | 0010 | 1110 | 0 | 1 | 0 | 1 | 0 | 0 | R2 | 2 | 3 | | 2 | 23 |
| 10111000 | 1110 | 0100 | 1 | 0 | 0 | 0 | 1 | 0 | R1 | 2 | 0 | | 2 | 24 |
| 01110000 | 0100 | 1100 | 0 | 1 | 0 | 0 | 0 | 1 | R3 | | 0 | 0 | | 25 |
| 11100000 | 1100 | 1000 | 0 | 0 | 1 | 0 | 1 | 0 | R4 | | 1 | 0 | | 26 |
| 11000001 | 1000 | 1001 | 0 | 1 | 0 | 0 | 0 | 1 | R3 | | 1 | 1 | | 27 |
| 10000011 | 1001 | 0001 | 0 | 0 | 1 | 0 | 1 | 0 | R4 | | 2 | 1 | | 28 |
| 00000111 | 0001 | 0011 | 0 | 1 | 0 | 0 | 0 | 1 | R3 | | 2 | 2 | | 29 |
| 00001110 | 0011 | 0010 | 0 | 0 | 1 | 0 | 1 | 0 | R4 | | 3 | 2 | | 30 |
| 00011101 | 0010 | 0111 | 0 | 1 | 0 | 1 | 0 | 0 | R2 | 0 | 3 | | 4 | 31 |

EP 2 342 540 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6330522 B1